# EUROPEAN PATENT APPLICATION

(11) **EP 3 761 510 A1**
(43) Date of publication of application: **06.01.2021**
(21) Application number: 19184000.8
(22) Date of filing: 02.07.2019
(51) Int. Cl.: H03K 17/96, G06F 3/041, G01N 27/60

(54) **THIN-FILM BASED TRIBOELECTRIC MATERIAL AND TOUCH SENSORS**

(71) Applicant: SABIC Global Technologies B.V., 4612 PX Bergen op Zoom (NL)
(72) Inventor: TAYEB, Mohammed Abdulwahab, 23955-6900 Thuwal (SA); CARAVEO FRESCAS, Jesus Alfonso, 23955-6900 Thuwal (SA); ALSALEM, Fahad Khalid, 23955-6900 Thuwal (SA); ALSHARIF, Yasir Fahad, 23955-6900 Thuwal (SA); FARAH, Abdiaziz, 23955-6900 Thuwal (SA)
(74) Representative: Elzaburu S.L.P.

(57) **Abstract**

A triboelectric device, system, and related methods are disclosed. An example device can comprise a thin-film triboelectric layer and an electrode coupled to the triboelectric layer. The thin-film triboelectric layer can be configured to output, to a circuit element and based on mechanical contact with an object, a current signal indicative of a material of the object. The circuit element can be configured to output a signal indicative of the material.

## Description

### Technical Field

The disclosure generally relates to thin films, and more particularly to thin-film devices comprising thermoplastic compositions that produce electrical energy when mechanically actuated, known as triboelectric sensors.

### Background

A sensor can be an integrated device that can provide specific qualitative and/or quantitative analytical information about one or more specimens. This can be through a transducer element that can be subjected to external physical stimuli. An external physical stimuli can be heat, light, sound, pressure, a magnetic field, or combinations thereof. Example sensors can include ultrasonic sensors, photoelectric sensors, capacitive sensors, and inductive sensors.

These conventional sensors often suffer from drawbacks, such as being limited to certain applications or being undesirably expensive. Fabrication of a single application sensor can be more expensive than fabrication of multi-application sensors, at least because of a decrease in manufacturing expenses that correlate with higher volume product. Also, fabrication can be more expensive than is desired because certain application-specific sensors can be over-sized for other applications, thereby requiring an excess of material and material processing. Another weakness of conventional devices is their reliance on templates and forms that prevent them from being integrated into a variety of different applications. The need of developing sensitive and reliable sensors that address these current limitations are warranted. Thus, there is a need for improved triboelectric sensors.

### Summary

As described herein, the present disclosure describes the development of devices that efficiently convert small mechanical energy into electricity through electrification contact effect. An example device as disclosed herein can comprise a sensor, such as a contact sensor and/or material sensor. Unlike conventional triboelectric sensors, a single sensor can be used to detect mechanical contact as well as the material of the object in contact with the sensor. An example device can comprise a triboelectric layer coupled to an electrode. The triboelectric layer can comprise a thin-film layer allowing fabrication of the device according to a variety of sizes for integration into different applications. The triboelectric material can be formulated with various polymeric materials to achieve a stronger, more easily detectable signal than conventional triboelectric sensors.

The triboelectric layer can produce electrical signals of varying characteristics, such as varying amplitude, in response to mechanical contact (e.g., or proximity) to with different materials. The differences in signal characteristics based on differences in materials allows for characterization of material properties of objects in contact with the device. Unlike conventional triboelectric sensors, the triboelectric layer can be electrically coupled to a processing unit or other circuit element that indicates the material properties in response to different the signal characteristics.

Additional advantages will be set forth in part in the description which follows or can be learned by practice. It is to be understood that both the foregoing general description and the following detailed description are exemplary and explanatory only and are not restrictive.

### Brief Description of the Drawings

The above-mentioned and other features and advantages of this disclosure, and the manner of attaining them, will become apparent and be better understood by reference to the following description of one aspect of the disclosure in conjunction with the accompanying drawings, wherein:
Figure 1 is a diagram showing an example device in accordance with the present disclosures.
Figure 2 is a diagram showing another example device with surface patterning.
Figure 3 is a diagram showing the use of multiple sensors to detect different touch events and type of materials.
Figure 4 is a diagram showing materials detection analysis by current and touch analysis by voltage using materials detection sensor.
Figure 5A is a diagram showing an example circuit configuration of a device according to the disclosure.
Figure 5B is a flowchart showing communication of signals for a sensor event.
Figure 6 is a diagram showing example detailed structure of a processing unit.
Figure 7A shows a triboelectric layer on a rigid substrate.
Figure 7B shows a triboelectric layer on a flexible substrate.
Figure 8A shows an example load cell.
Figure 8B shows a view of the load cell in an example case.
Figure 8C shows another view of the example case.
Figure 9 is a graph showing the output force from the load cell for selected touch events.
Figure 10 is a graph showing a typical current output recording from the example material detection sensor.
Figure 11 is a graph showing the current response of a material detection sensor as a function of resistance.
Figure 12 is a graph showing average current response as a function of applied force, for different materials tested, using a first material as active layer.
Figure 13 is a graph showing average current response as a function of applied force, for different materials tested, using a second material as active layer.
Figure 14 is a graph showing average current response as a function of applied force, for different materials tested, using a third material as active layer.
Figure 15 is a graph showing the average current response per each material tested for different active materials.
Figure 16 is a graph showing the output response (e.g., voltage measurement) of the presented triboelectric sensor in response to a dynamic input.
Figure 17 is a block diagram illustrating an example computing device for implementing one or more aspects of the disclosure.

### Detailed Description

A device and related methods and systems based on triboelectric principles are disclosed. The device can comprise a material detection sensor and/or a touch event sensor. The device can detect different physical contacts but also can determine uniquely physical and chemical makeup of the materials that has created the tactile event. Furthermore, the device can determine many different materials by virtue of the charge density difference across the triboelectric series, allowing for integration in myriad of applications where identifying the type of material in contact is critical.

The present disclosure includes the fabrication of a novel triboelectric nanocomposite sensor from a blend of photoactive polycarbonate thermoplastic material (XPC) and Isofluoropropyl polyhedral oligomeric silsesquioxane (F-POSS). This material exhibited higher voltage output than conventional materials without a need for further processing steps. The present disclosure also describes an architecture of implementing a material detection sensor and touch sensor into a device or system. The present techniques are scalable to a large-scale manufacturing level. An example sensor can include a single thin-film component (e.g., or layer, such a sensor), a plurality of thin film components (e.g., thin-film sensor, thin-film processor), and/or the like.

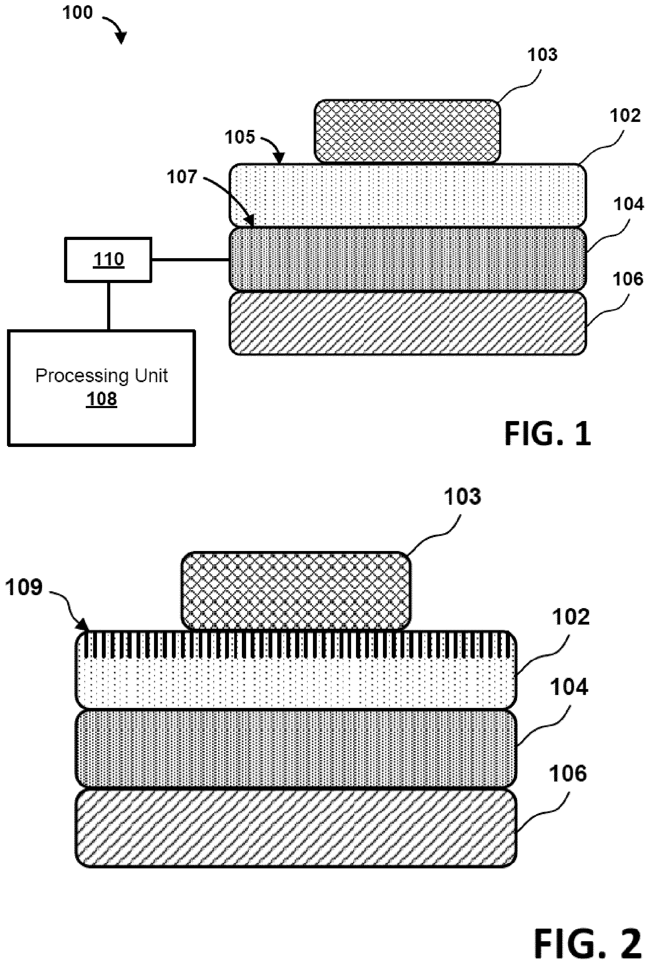

FIG. 1 is a diagram showing an example device 100 in accordance with the present disclosures. The device 100 can comprise a sensor, such as a sensor that relies on the triboelectric effect.

The device 100 can comprise a triboelectric layer 102. The triboelectric layer 102 can comprise a thin-film layer. A thin-film layer (e.g., triboelectric layer 102) can be a monolayer. The thin-film layer (e.g., triboelectric layer 102) can have a thickness of within a range of from about a nanometer to about several micrometers (e.g., or about several hundred micrometers). The thin-film layer (e.g., triboelectric layer 102) can have a thickness of about 1 µm to about 500 µm, about 1 µm to about 300 µm, or 1 µm to about 200 µm.

The triboelectric layer 102 can output a signal based on a triboelectric effect. The triboelectric layer 102 can be configured to output a current signal in response to an interaction (e.g., mechanical contact, contact event, proximity event, mechanical force, electrical force). with an object 103. The triboelectric layer 102 can comprise a triboelectric material. The triboelectric material can comprise a polymer. The polymer may comprise a fluorinated polymer. The triboelectric material can comprise one or more of photoactive polycarbonate thermoplastic material (XPC) or isofluoropropyl polyhedral oligomeric silsesquioxane (F-POSS). The triboelectric material can comprise photoactive polycarbonate thermoplastic and isofluoropropyl polyhedral oligomeric silsesquioxane (XPC-F-POSS). XPC-F-POSS can comprise a polycarbonate polymer (e.g., XPC) with about 3.5% weight of benzophenone moieties in the polymer chain.

XPC is a photoactive cross-linkable polycarbonate resin that includes about 0.5 mole % to about 5 mole % endcap groups derived from the monohydroxybenzophenone, including from about 1 mole % to about 3 mole, or from about 1.7 mole % to about 2.5 mole %, or from about 2 mole % to about 2.5 mole %, or from about 2.5 mole % to about 3.0 mole %, or from about 3.5 mole % to about 4.0 mole % endcap groups derived from the monohydroxybenzophenone. Most desirably, the monohydroxybenzophenone is 4-hydroxybenzophenone. In a particular aspect the resin includes about 3.5 mole % endcap groups derived from 4-hydroxybenzophenone, as shown in formula (1) below:

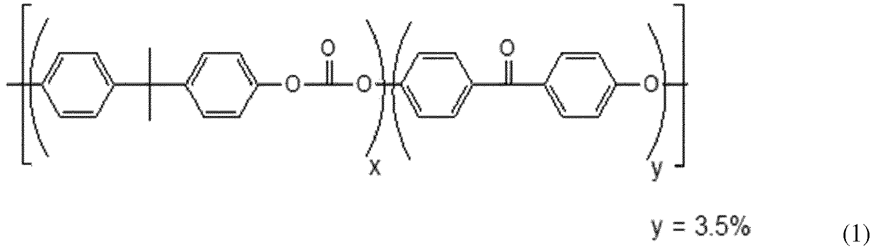

XPC may be formed in accordance with the methods described in U.S. Patent Publication No. 2017/0247507, the disclosure of which is incorporated herein by this reference in its entirety.

F-POSS is isofluoropropyl polyhedral oligomeric silsesquioxane, and has the chemical structure shown in formula (2):

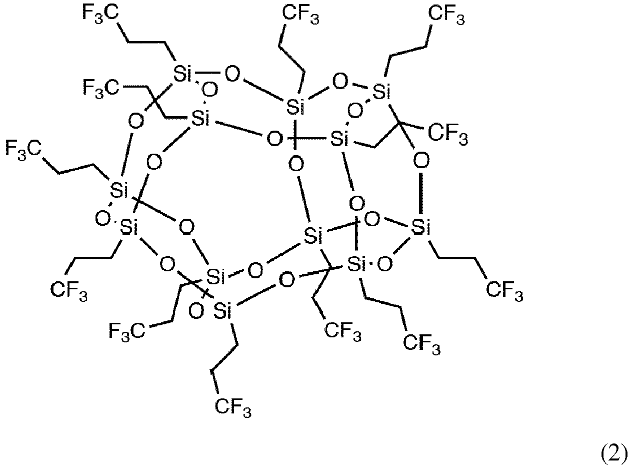

The triboelectric material can comprise photoactive polycarbonate isofluoropropyl polyhedral oligomeric silsesquioxane (XPC-F-POSS), polyvinylidene difluoride (PVDF), polydimethylsiloxane (PDMS), poly(methyl methacrylate) (PMMA), polytetrafluoroethylene (PTFE), polymer foams, poly(methyl methacrylate)-co-poly(1H-1H-perfluoroctyl methacrylate), acetate, mica, nylon, perfluorinated polymers, copolymers of the described polymers, and combinations thereof. The triboelectric material can comprise Polyvinyl chloride (PVC), polytetrafluoroethene (PTFE) (e.g., Teflon™), Polyvinylidene chloride (PVDC), polycarbonate (PC), functionalized PC, Polyvinylidene difluoride trifluoroethylene (PVDF-TrFE), a combination thereof, and/or the like.

The triboelectric layer 102 can comprise a first side 105. The triboelectric layer 102 can comprise a second side 107. The second side 107 can be opposite the first side 105. The first side 105 can receive the interaction with the object 103. The first side 105 can receive contact with the object 103. The interaction can comprise a touch event, placing a material on the first side 105, moving the first side 105 to come in contact with the object 103, and/or the like. In some implementations, the first side 105 can comprise a surface patterning 109, as shown in FIG. 2. The surface patterning can enhance (e.g., increase) the contact surface area and/or the friction coefficient of the triboelectric layer 102. Example sensor structures and effects of the surface patterning can be found in International Publication No. WO 2018002752 A1 filed on June 12, 2017, which is hereby incorporated by reference in its entirety.

The device 100 can comprise an electrode 104 disposed adjacent the triboelectric layer 102. As used herein, the term adjacent when used in relation to a layer can comprise next to, in contact with, above, on top of, below, coupled to, or a combination thereof. The term adjacent can allow for one or more intervening layers between two layers that are adjacent. The electrode 104 can be in contact with a second side 107 of the triboelectric layer 107. The electrode 104 can comprise a thin-film layer. The electrode 104 can comprise a conductive material, such as a metal. The electrode 104 can comprise titanium, gold, a combination thereof, and/or the like.

The device 100 can comprise a substrate 106 disposed adjacent the triboelectric layer 102, the electrode 104, or a combination thereof. The electrode 104 can be disposed on top of (e.g., in contact with) the substrate 106. The substrate 106 can comprise a rigid or flexible material. The substrate 106 can comprise a thin-film layer. The substrate 106 can comprise a polymer, such as polyimide, and silicon comprising a layer of polyimide. The substrate 106 can comprise Polyetherimide, Polyethylene naphthalate (PEN), Polyethylene terephthalate (PET), Polycarbonate, one or more thin sheets of metal, and/or a combination thereof. An example rigid material can comprise an indium tin oxide (ITO) coated glass.

The device 100 can comprise a processing unit 108. The processing unit 108 can comprise a computer processor, a microcontroller, a field programmable gate array, a plurality of logic gates, an integrated circuit, a combination thereof, and/or the like. The processing unit 108 can be electrically coupled (e.g., via at least the electrode 104) to the triboelectric layer 102. The processing unit 108 can be configured to receive the current signal. The processing unit 108 can be implemented as one or more thin-film layers.

The device 100 can comprise a readout circuit 110. The readout circuit 110 can be implemented as one or more thin-film layers. In some implementations, the readout circuit 110 can be comprised in the processing unit 108. The readout circuit 110 can be electrically coupled to the electrode 104. The readout circuit 110 can be electrically coupled between the triboelectric layer 102 and the processing unit 108. The readout circuit 110 can be electrically coupled between the electrode 104 and the processing unit 108. The readout circuit 110 can be configured to receive a current signal from the triboelectric layer 102 (e.g., via the electrode 104). The current signal can be generated by the triboelectric layer 102 in response to an interaction (e.g., mechanical contact, contact event, proximity event, mechanical force, electrical force). The readout circuit 110 can be configured to generate a voltage signal based on the current signal. The readout circuit 110 can supply the current signal, the voltage signal, electrical charge, or a combination thereof. In some scenarios, the output of the readout circuit might be altered based on a change in internal impedance.

The readout circuit 110 can comprise an active readout circuit, a passive readout circuit, and/or the like. The readout circuit 110 can be configured to generate signals readable by the processing unit 108 based on changes in a current signal (e.g., that can be too small for the processing unit 108 to detect) from the triboelectric layer 102. The readout circuit 110 can comprise one or more circuit components, such as a load element, a resistor, a transistor, a buffer element, an inverter, a differential amplifier, a charge sense amplifier, as switch, a capacitor, a combination thereof, and/or the like.

The processing unit 108 can be configured to analyze signals (e.g., current signals, voltage signals) received or otherwise measured from one or more of the triboelectric layer 102, the electrode 104, the readout circuit 110, or a combination thereof. The processing unit 108 can be configured to receive signal from a plurality of triboelectric layers (e.g., though only one is shown for purposes of illustration. The processing unit 108 can be configured to analyze one or more signals caused by an interaction to determine a force of the interaction, an occurrence of the interaction, a duration of the interaction, a geometry of the interaction (e.g., or object), a material of the object, a combination thereof, and/or the like.

The processing unit 108 can be configured to determine, based on the current signal, a material of the object. The processing unit 108 can be configured to determine the material of the object based on determining that the current signal has a current characteristic associated with the material. The current characteristic can comprise a current level (e.g., amplitude). The processing unit 108 can store a plurality current characteristics associated with corresponding materials. For example, a first current level can be associated with a first material. A second current level can be associated with a second material. A third current level can be associated with a combination of the first material and the second material. The processing unit 108 can use a measured current level and the associations of materials and current levels to determine one or more materials sensed in the object 103. The processing unit 108 (e.g., or the readout circuit 110) can convert the current value to a voltage value. The voltage value can represent the current characteristic, current level, and/or the like. The voltage value can be used to determine the material of the object.

The processing unit 108 can be configured to determine an occurrence of a touch event based on a voltage signal. A change in the voltage signal, such as a voltage peak can be used to determine that a touch event occurred. The voltage signal can have an amplitude above a threshold can be used to determine a touch event occurred. Various voltage thresholds can be associated with corresponding force levels. The force of a contact event can be determined by matching the voltage with a corresponding force level. The time length can be determined based on a time associated with a beginning of detecting the voltage signal and a time associated with an end of detecting the voltage signal. The processing unit 108 can comprise a thin-film processor. The processing unit 108 can comprise a programmable processor or controller (e.g., a microprocessor such as Arduino). A program can be loaded into the processing unit 108 (e.g., processor/controller). The program can comprise instructions for configuring the processing unit 108 to determine, based on a received signal, one or more data values (e.g., or metrics), such as the occurrence of a contact event, the force of the contact event, a beginning of a contact event, an end of a contact event, and/or the time length of the contact event. The processing unit 108 can store a history of data values.

The device 100 (e.g., or sensor) can be integrated into a variety of devices, systems, and other applications. The device 100 can be used to detect human contact. The device 102 can be part of a device or system configured to avoid human interaction with a given product or to protect from injuries. The device 100 can be used to differentiate between bare human hand or a protected human hand with appropriate glove. The device 100 (e.g., or sensor) can be comprised in a robotic hand to detect material that is being handled by the robotic hand. The device 100 (e.g., or sensor) can be comprised in an electronic skin, a sensor for prosthetics, a material sorter (e.g., material segregation for recycling), a counterfeit detection device (e.g., as a sensor to verify the material is authentic or counterfeit), as a material detector for quality control, a combination thereof, and/or the like.

Additional details regarding the device 100 are described as follows. The device 100 can generate a current level that is unique for the type of material that contacts the triboelectric layer 102. The current level is a result of the number of charges generated by the device 100 due to the principle of triboelectricity and electrostatic potential differential between two surfaces of different electro-affinity. Touch detection can be detected by measuring the voltage drop across the readout circuit 110 (e.g., which can be as simple as an electrical load (resistor)) connected to the electrode 104. For the particular configuration shown in FIG. 1, where the device 100 comprises only one electrode, the object/material to be identified can act as the ground electrode to complete the electrical circuit. Upon contact, the layers with different electro-affinity gave rise to the triboelectric effect.

The device 100 can comprise multiple sensors that act individually as touch or materials detection sensor or simultaneously where one sensor acts with dual functions. For example, the device 100 can comprise a first sensor configured to detect materials and a second sensor configured to detect touch events. The device 100 can comprise a third sensor configured to detect both material and touch of an object.

The device 100 can operate by placing a material to be detected on top of the triboelectric layer 102. The triboelectric layer 102 can be the top most surface of the device 102 (e.g., or a sensor portion of the device 100). The triboelectric layer 102 can comprise a first material having a tendency to donate electrons while an object in contact with the triboelectric layer can comprise a second material having a tendency to capture those electrons, where the object to be tested could donate or capture electrons. In some scenarios, a first triboelectric layer can have a negative electro-affinity and a second triboelectric layer can have a positive electro-affinity. Objects of different electro-affinities can be sensed using either one of the first triboelectric layer or the second triboelectric layer. By placing in contact materials having different triboelectric properties (e.g., electro affinities), a transfer of charges is created between those materials which can be reflected in the form of voltage differential or current flow. The current response in the device 100 can be proportional to the difference of electro-affinity between contact surfaces. The working principle of the device can be based on the generated charges based on the triboelectric layer 102 being in contact with a material having an opposite or varying electro-affinity.

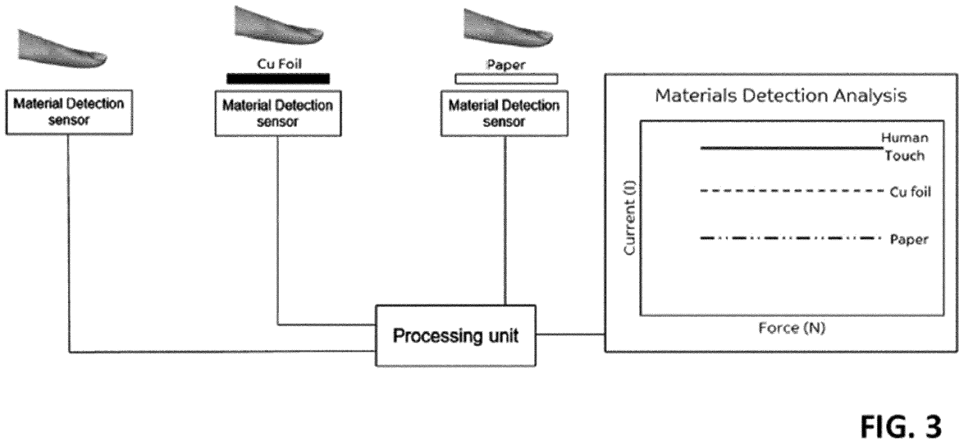

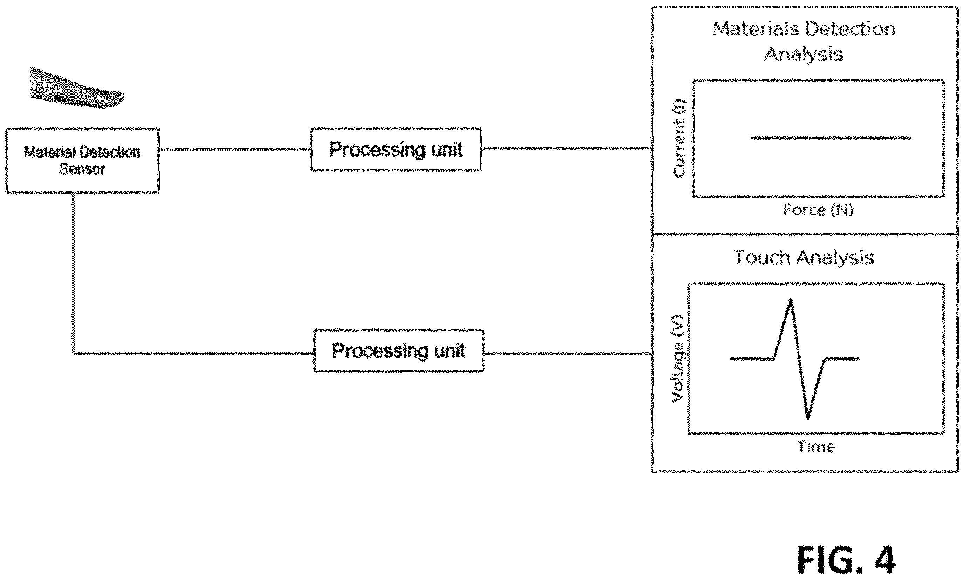

The basic operational principle of the disclosed device (e.g., materials detection/touch sensor) is described in FIG. 3 and FIG. 4. FIG. 3 is a diagram showing the use of multiple sensors to detect different touch events and type of materials. FIG. 4 is a diagram showing materials detection analysis by current and touch analysis by voltage using materials detection sensor. The material detection sensors can comprise the triboelectric layer 102, the electrode 104, the substrate 106, or a combination thereof of FIG. 1. The device can utilize a current response that is generated as a property of each material to differentiate between different surfaces that come into contact with the sensor, as illustrated in FIG. 3. The observed current output can be unique for each material. The device (e.g., or processing unit 108) can be able to differentiate independently with respect to the force applied to it. The output voltage can be a function of applied force and can increase with increasing pressure (or force). The current response can show insignificant changes with the applied pressure. Both voltage and current outputs can be used by the device. Voltage response (e.g., measured in the open circuit condition) can be used to identify the touch event. Current response (e.g., measured in the short circuit condition) can be a materials related-property and used to differentiate the materials that come into contact, as shown in FIG. 4.

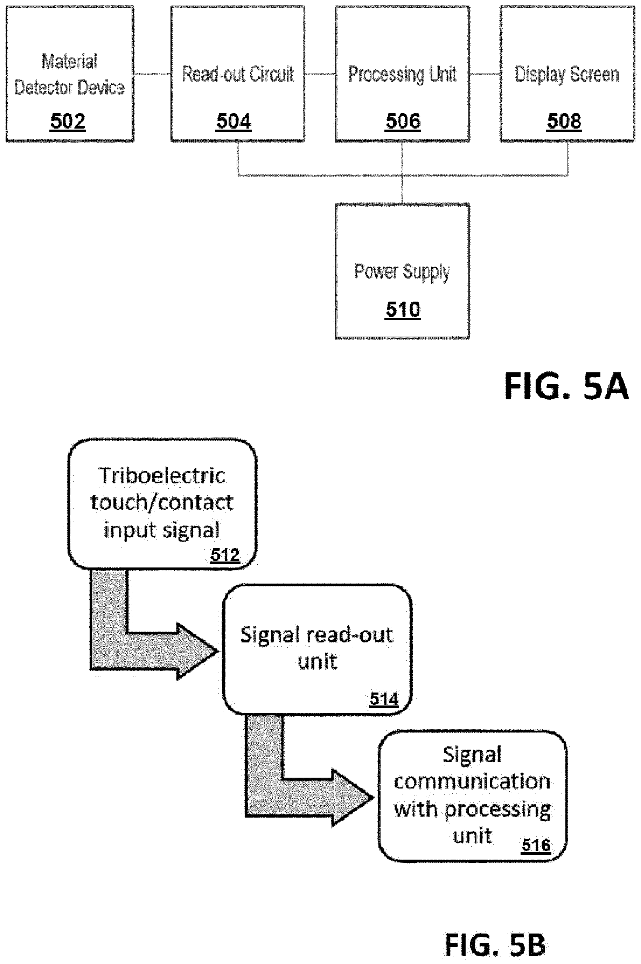

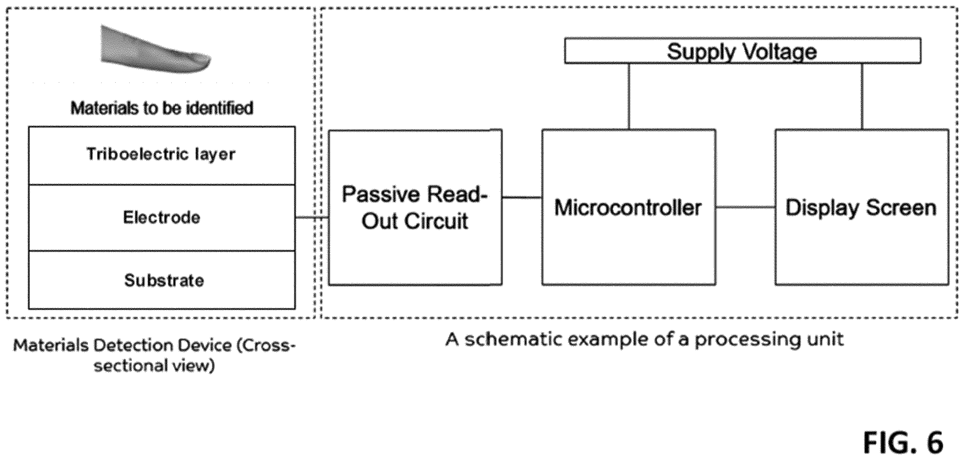

Figs. 5A-B and FIG. 6 show block diagrams and schematics of the overall system to be used as a material-type detector. FIG. 5A is a diagram showing an example circuit configuration of a device according to the disclosure. FIG. 5B is a flowchart showing communication of signals for a sensor event. FIG. 6 is a diagram showing example detailed structure of a processing unit.

As shown in FIG. 5A, an example device (e.g., or system, sensor) can comprise a material detector 502, a readout circuit 504, a processing unit 506, a display screen 508, a power supply 510, a combination thereof, and/or the like. The material detector 502 can comprise one or more of the triboelectric layer 102, the electrode 104, or the substrate 108. The power supply 510 can be electrically connected to (e.g., and provide power to) one or more of the readout circuit 504, the processing unit 506, the display screen 508. The power supply 510 may not be electrically connected to the material detector 502. The readout circuit 504 can be configured to convert a signal and/or change in state of the material detector 502 to a current signal and/or voltage signa. The readout circuit 504 can be configured to condition (e.g., amplify) a signal received from the material detector 504 and supply one or more signals to the processing unit 506.

The processing unit 506 can analyze the one or more signals received and determine one or more conditions, such as the occurrence of contact with the material detector 502, a type of material that contacted the material detector 502, an amount of force (e.g., or pressure) of the contact, a combination thereof, and/or the like. The processing unit 506 can store the one or more conditions in memory (e.g., not shown). The processing unit 506 can cause the display screen 508 to output the one or more conditions. For example, the occurrence of contact with the material detector 502, a type of material that contacted the material detector 502, an amount of force (e.g., or pressure) of the contact, a combination thereof, and/or the like can be caused to be displayed on the display screen 508.

As shown in FIG. 5B, at step 512, a triboelectric-based sensor can generate a unique current value (e.g., or current signal) for different materials tested. The current value can be supplied to a read-out circuit. At step 514, the read-out circuit can convert the current value (e.g., or current signal) into a voltage value (e.g., voltage signal). The current value and/or the voltage value can be supplied to the processing unit. At step 516, the processing unit (e.g. microcontroller) can be used to read the resultant current and/or voltage and identify the type of the material accordingly, and then display it on a screen. As an example, in response to contact event, an output signal (e.g., current) is generated between bare or protected human finger and the triboelectric layer. A read-out unit can interpret the current signal and communicates it to a processing unit, such as mobile device or computer.

It should be appreciated that the devices disclosed herein can be implemented in a variety of applications, using any appropriate material and manufacturing process. The device can be an improvement over conventional devices due to simplicity, scalability, ease of fabrication, and/or other features described herein. The devices disclosed here may be implemented as a sensor. The device can be a thin-film sensor or a thick-film sensor. The device can be configured to detect touch events, materials (e.g., chemical composition) of objects in contact with the sensor, and/or the like. Different materials can be detected based on matching current characteristics to corresponding materials. The sensing can be independent of the force of contact between an object and the sensor. The device may be self-generating such that contact with the device is sufficient to generate a signal (e.g., without an external power source).

The device may be implemented in a single electrode configuration or a multiple electrode configuration. The device can be mechanically bendable, flexible, optically transparent, translucent, opaque, and/or the like. The device disclosed herein can be built using microfabrication techniques, inkjet printing, molding, extrusion, a combination thereof, and/or the like. The device disclosed herein can be integrated into 3D structures and surfaces.

### Methods of Making

In this section, description of the fabrication and characterization of the designed triboelectric sensors is disclosed. Though the following is illustrated using example values, processes, and materials, it is contemplated that other materials, processes, and values can be used according to design specifications.

Step 1. A substrate was prepared, cleaned, and/or procured. The substrate can be flexible or rigid. Both, ITO coated glass (2.54x2.54 cm2) and 125 µm thick Polyethylene naphthalate (PEN) (3.6x1.4 cm2) substrates, were used to fabricate various example devices. The substrate was cleaned with Acetone, isopropanol (IPA), and deionized water, for 5 minutes each in an ultrasonic bath, followed by blown-drying with high purity nitrogen.

Step 2. Electrode Deposition was performed. For a rigid substrate, the already deposited ITO coating is used as the electrode layer. For a flexible substrate (e.g., PEN substrate), electrodes were deposited by electron beam evaporation. The electrodes can be patterned in the desired geometry using a predesigned shadow mask. As an example, a 20 nm Titanium/ 80 nm gold electrode was formed.

Step 3. Triboelectric layer deposition was performed. As an example, the following electronegative triboelectric materials were chosen: Polyvinylidene fluoride (PVDF), Polyvinyl chloride (PVC), and blends of photoactive polycarbonate (XPC) and Isofluoropropyl polyhedral oligomeric silsesquioxane (F-POSS). The example formulations were prepared by dissolving XPC in dimethyl-formamide (DMF), which were stirred for 3 hours to have a 20 wt% solution. 15 wt% loading (with respect to XPC) of F-POSS was added to the solution and stirred for 3 hours. Similarly, PVDF and PVC, were dissolved in dimethyl-formamide (DMF) and Tetrahydrofuran (THF), respectively and stirred until 15 wt% formulations were obtained. Then, the solutions were spin coated on the electrode-coated substrates. In the example devices, the spin coating was performed at a fixed spin speed of 1000 rpm to obtain the following thicknesses: 3.95, 3.7, and 8 µm for XPC-F-POSS, PVDF, and PVC, respectively. Finally, the devices can be cured in a conventional oven. For the examples, the devices were cured for 2-4 hours at 50-100°C, under vacuum.

Step 4. Testing materials were selected. Many contact materials were been tested including bare human finger, nitrile glove - rubber -, PVC films, PVDF films, PC film, Aluminum foil, white paper, Cupper foil, thick glass and Ultem (polyetherimide) sheet. The materials were chosen to vary in the electro-affinity series* (from high electropositive materials i.e. human skin to high electronegative materials i.e. PVDF). PC, PVDF, and PVC films were obtained by casting the appropriate solution on a glass holder, cured with compressed air for few hours and lastly cured in a conventional oven for 2 hours 50oC, under vacuum. Once cooled down, these films were manually peeled from the glass substrate and cut to the desired size.

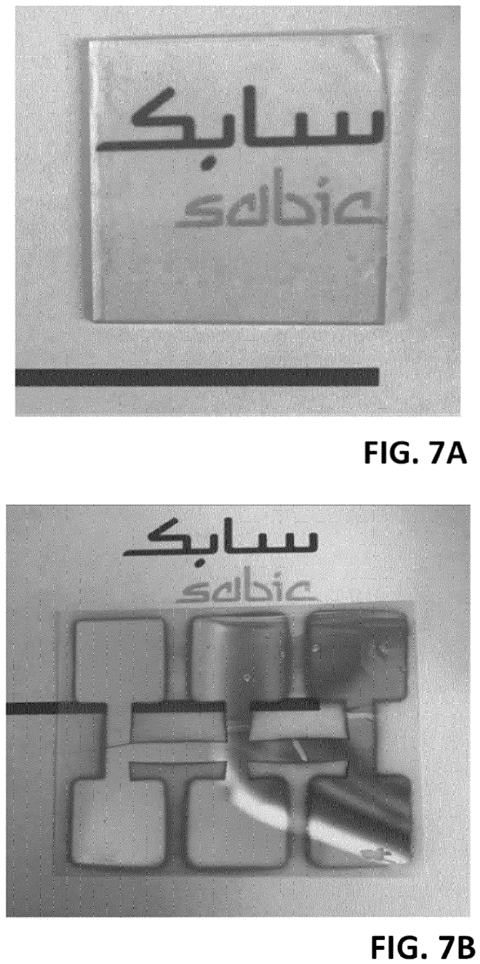

The results presented herein correspond to the statistical analysis of several devices prepared in both the rigid and flexible substrates. All devices were characterized using the aforementioned materials in contact with the three different triboelectric layers for validation purposes. FIG. 7A-B shows optical images of the fabricated sensors. FIG. 7A shows an optical image of an XPC-F-POSS triboelectric layer on ITO glass. FIG. 7B shows an XPC-F-POSS triboelectric layer on flexible PEN.

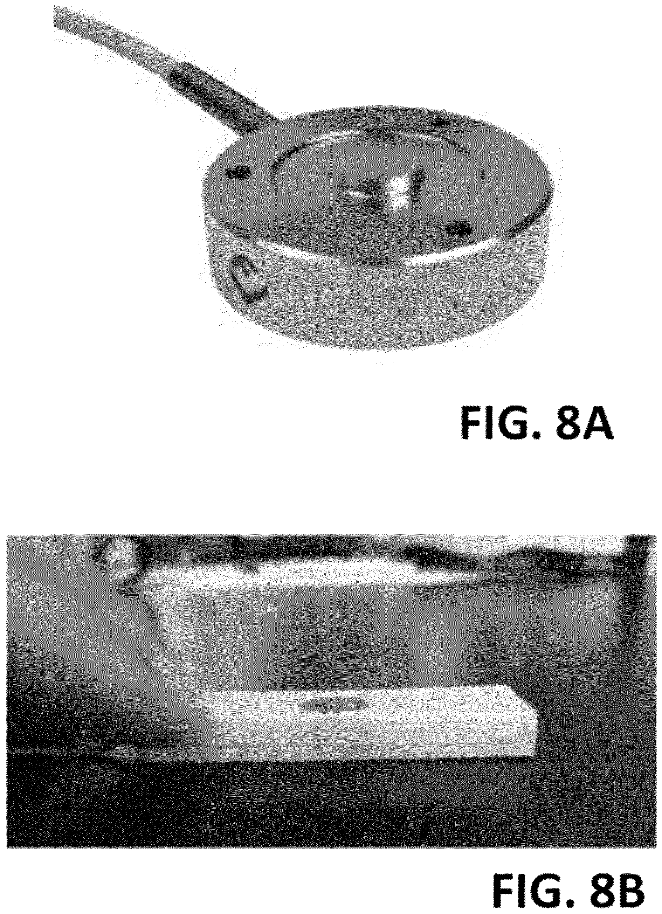

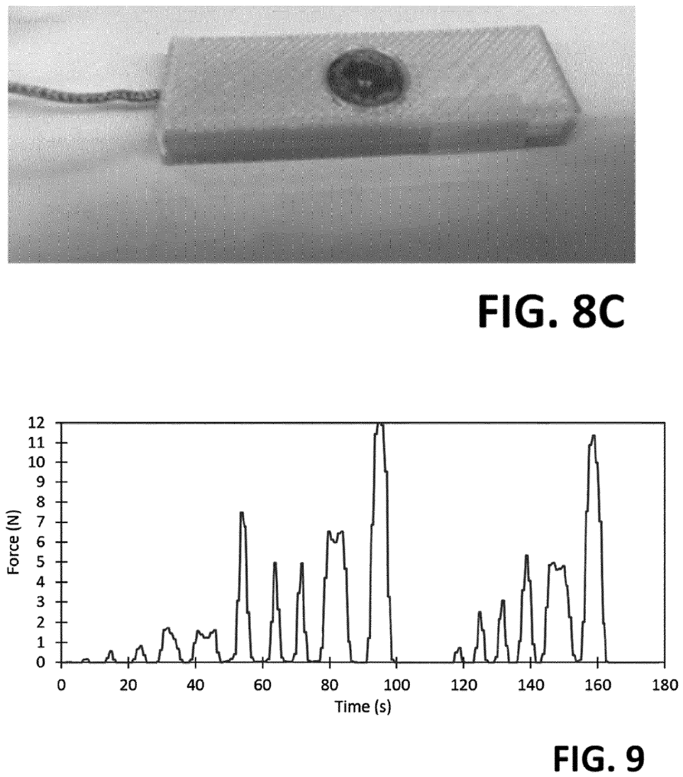

The example triboelectric sensor was characterized as follows. Current generated by the material detection sensor was obtained using Tektronix TDS 2024B Oscilloscope connected to SR570 low noise current Preamplifier in the short circuit configuration. Measurements were conducted as a function of force, achieved by varying the pressure (Pressure = Force/Area) applied to the sensor with the different test materials contacting the triboelectric layer. OpenChoice software was used to record the electrical current generated upon contact of test materials with the triboelectric layer. Force applied to the example sensor was recorded using a load cell installed in a custom-made 3D printed case, as shown in FIG. 8A-C, to hold the sensor in place. The example load cell was a FUTEK button load cell. FIG. 8A shows the example load cell. FIG. 8B shows a view of the load cell in an example case. FIG. 8C shows another view of the example case. Both the force and material detection sensors were contacted at the same time to record simultaneously their corresponding outputs.

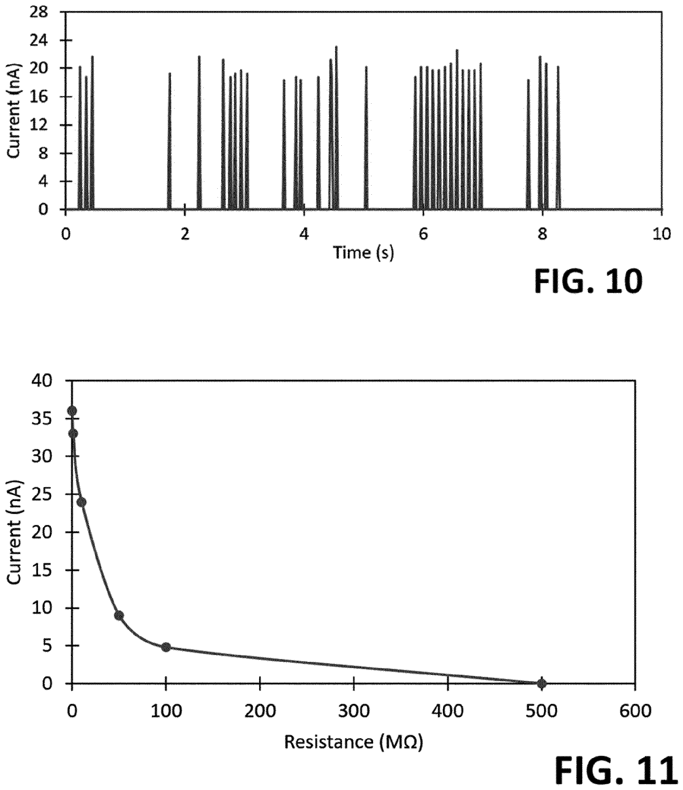

FIG. 9 is a graph showing the output force from the load cell for selected touch events. The force recordings were taken over a 3 minute period at 0.1 second interval, on XPC-F-POSS on flexible PEN. FIG. 10 is a graph showing a typical current output recording from the example material detection sensor upon dynamic excitement using a PVC-based triboelectric layer and a human finger as the test material. All device measurements were performed under ambient conditions.

Peak output current can be measured under a short circuit configuration (e.g., no electrical load connected to the system), whereas voltage output can be maximized by carefully selecting the load connected to the system. FIG. 11 is a graph showing the current response of the material detection sensor (using XPC-F-POSS as the triboelectric layer) as a function of resistance (load). The graph confirms the maximum output current at zero ohms (short circuit condition). Current output decreases with increasing resistance, reaching zero Amps at about 500 MΩ. Therefore, all the current measurements for this work were conducted at no additional resistance (short circuit standard).

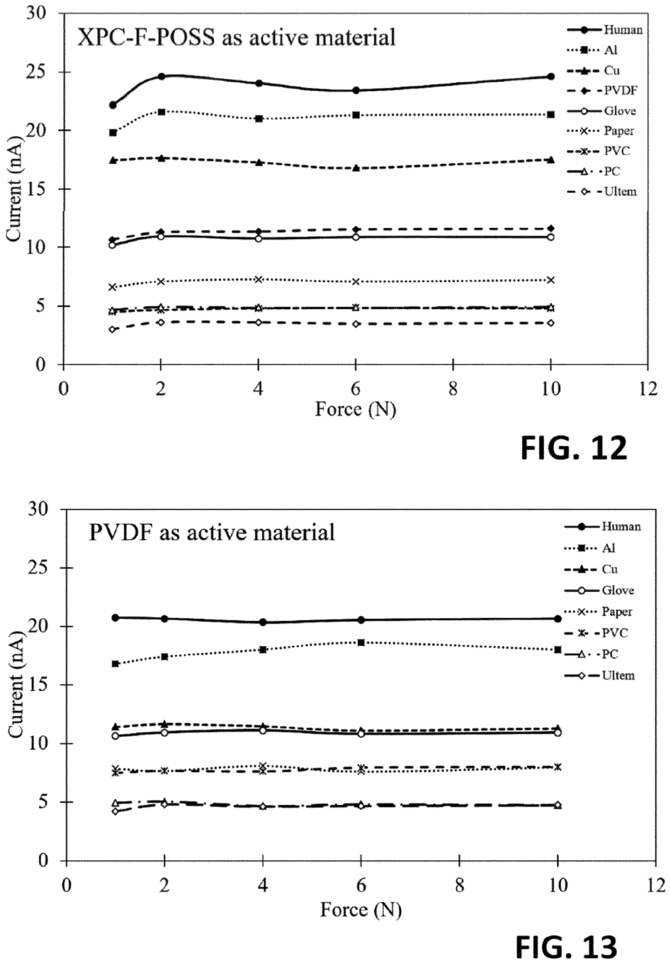

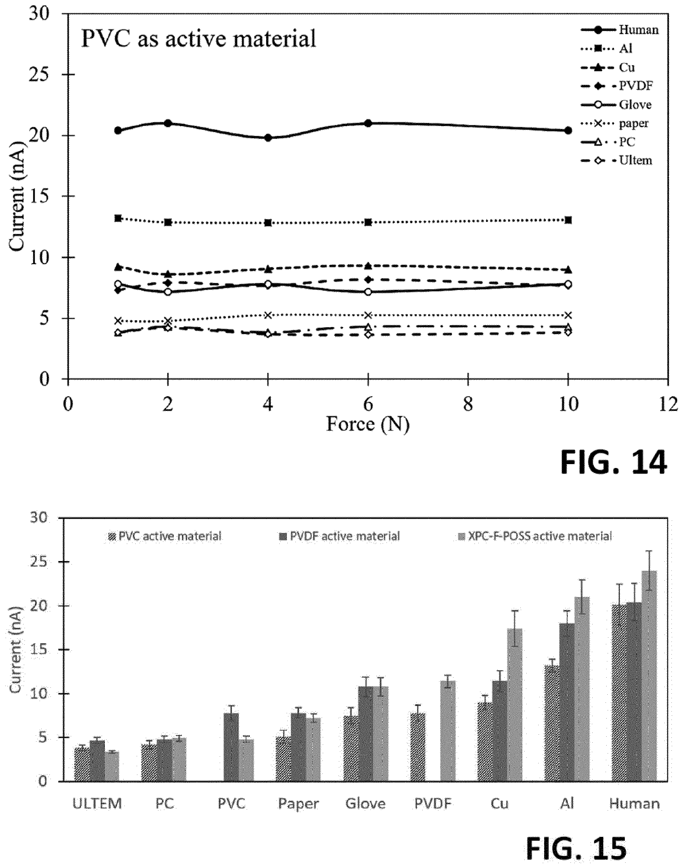

As mentioned above, voltage output of triboelectric sensor increases with increasing the input force. Therefore, a material differentiation sensor can be configured to not exhibit a force dependent response that can compromise its selectivity. As the working principle is based on the electronegativity differential between the surfaces in contact, current output should be a function of the number of charges transferred upon contact and the electrostatic potential differential of the layers with negligible force dependence. In order to confirm this behavior, current output measurements as a function of the force were conducted for the 3 triboelectric layers selected for this disclosure and depicted in FIGs. 12-14. FIG. 12 is a graph showing average current response as a function of applied force, for different materials tested, using XPC-F-POSS as active layer. FIG. 13 is a graph showing average current response as a function of applied force, for different materials tested, using PVDF as active layer. FIG. 14 is a graph showing average current response as a function of applied force, for different materials tested, using PVC as active layer.

Triboelectric layers where selected among the most electronegative materials found so far, while 10 different test materials were selected to cover the entire triboelectric series (from the most electropositive to most electronegative options). The test materials are listed as follows: Bare human finger, 27µm Aluminum foil, 89µm copper foil, 73µm nitrile glove, 98µm paper, 28µm PC film, 180µm Ultem sheet, 43µm PVC film, 7µm PVDF film.

As shown in these figures, regardless of the triboelectric layer being used, the current response is not affected by the force applied to the sensor as similar current outputs are recorded in the range of 1 to 10 N force input. These figures also show different current levels generated for the different test materials, confirming the material differentiation capabilities. Nonetheless, similar current outputs are found for certain materials (e.g. PVDF and glove if using XPC-F-POSS), showing some selectivity shortcomings, especially for materials with similar electronegativity. This shortcoming is more evident if using PVDF and PVC. If one compares the 3 graphs, it is possible to conclude that using a more electronegative layer (like XPC-F-POSS) enhances the sensor's selectivity.

FIG. 15 is a graph showing the average current response per each material tested for different active materials. PVC is shown with the left bar. PVDF is shown by the middle bar. XPC-F-POSS is shown with the right bar. The material differentiation sensor produces different electrical responses (current output) if touched with different materials. However, it can be difficult to differentiate among materials with close or similar electro-affinity such as paper, PVC, PC, and Ultem. These results show that the disclosed materials detection sensor is capable of differentiating between human touch, metals (Cu, Al), and polymers/plastics.

XPC-F-POSS is more electronegative than PVDF, and PVC. The results shown in FIG. 15 confirm that if using bare human finger, Al and Cu foils, the current response is higher for XPC-F-POSS, followed by PVDF, and finally PVC. These results support the hypothesis that current response is proportional to difference of electro-affinity between contact surfaces.

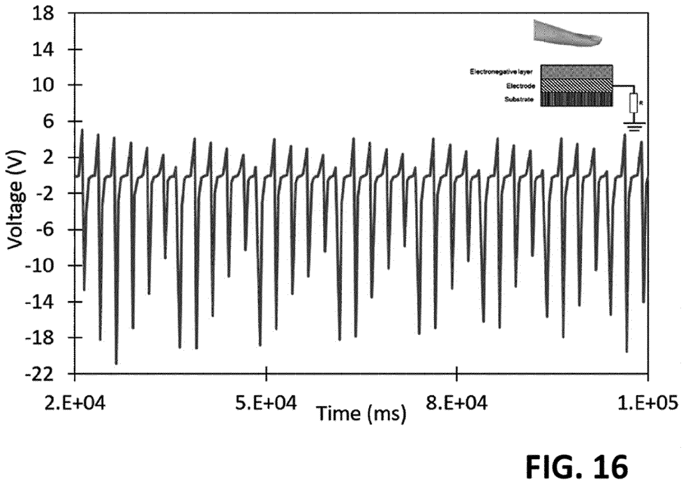

The device and sensor disclosed performs multiple functionalities. Besides being a materials detection sensor, it also acts as a touch/tactile sensor. Touch events are detected by looking at the voltage response of the sensor. Upon a contact with the sensor, the active layer (e.g., triboelectric layer) can collect charges on its surface which induce a voltage drop across a resistor (e.g., or other readout circuitry) connected to it as shown in FIG. 16. FIG. 16 is a graph showing the output response (e.g., voltage measurement) of the presented triboelectric sensor if a dynamic input is applied. The graph shows voltage output performance as a function of time for XPC-F-POSS triboelectric sensor with a 500 MΩ resistance. The dynamic input is generated by linear motor that simulates touch events at relatively consistent force and frequency.

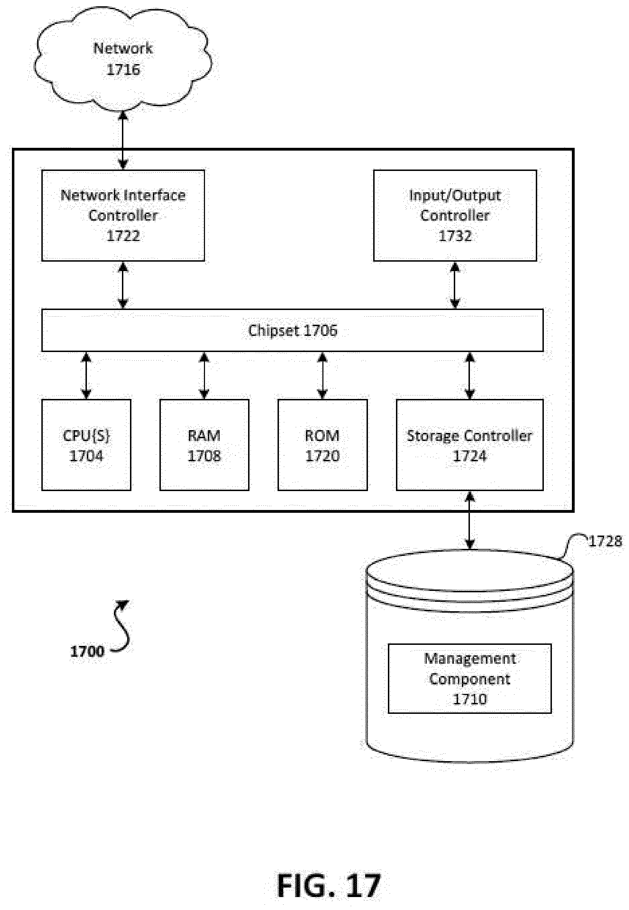

FIG. 17 depicts a computing device that can be used in various aspects, such as the devices and systems depicted throughout the disclosure. With regard to the example architecture of FIG. 1, the device 100 can be implemented in an instance of a computing device 1700 of FIG. 17. The computer architecture shown in FIG. 17 shows a conventional server computer, workstation, desktop computer, laptop, tablet, network appliance, PDA, e-reader, digital cellular phone, or other computing node, and can be utilized to execute any aspects of the computers described herein, such as to implement the methods described in relation to FIG. 5B and throughout the disclosure. As an example, the device 100 can determine data (e.g., materials, touch events). The device 100 can send the data to another device via network 1716. The other device can be a computing device of service, such as a cloud data service. The data can be accessed via the service by users in different locations (e.g., external to a premises or location of the device 100).

The computing device 1700 can include a baseboard, or "motherboard," which is a printed circuit board to which a multitude of components or devices can be connected by way of a system bus or other electrical communication paths. One or more central processing units (CPUs) 1704 can operate in conjunction with a chipset 1706. The CPU(s) 1704 can be standard programmable processors that perform arithmetic and logical operations necessary for the operation of the computing device 1700.

The CPU(s) 1704 can perform the necessary operations by transitioning from one discrete physical state to the next through the manipulation of switching elements that differentiate between and change these states. Switching elements can generally include electronic circuits that maintain one of two binary states, such as flip-flops, and electronic circuits that provide an output state based on the logical combination of the states of one or more other switching elements, such as logic gates. These basic switching elements can be combined to create more complex logic circuits including registers, adders-subtractors, arithmetic logic units, floating-point units, and the like.

The CPU(s) 1704 can be augmented with or replaced by other processing units, such as GPU(s) 1705. The GPU(s) 1705 can comprise processing units specialized for but not necessarily limited to highly parallel computations, such as graphics and other visualization-related processing.

A chipset 1706 can provide an interface between the CPU(s) 1704 and the remainder of the components and devices on the baseboard. The chipset 1706 can provide an interface to a random access memory (RAM) 1708 used as the main memory in the computing device 1700. The chipset 1706 can further provide an interface to a computer-readable storage medium, such as a read-only memory (ROM) 1720 or non-volatile RAM (NVRAM) (not shown), for storing basic routines that can help to start up the computing device 1700 and to transfer information between the various components and devices. ROM 1720 or NVRAM can also store other software components necessary for the operation of the computing device 1700 in accordance with the aspects described herein.

The computing device 1700 can operate in a networked environment using logical connections to remote computing nodes and computer systems through local area network (LAN) 1716. The chipset 1706 can include functionality for providing network connectivity through a network interface controller (NIC) 1722, such as a gigabit Ethernet adapter. A NIC 1722 can be capable of connecting the computing device 1700 to other computing nodes over a network 1716. It should be appreciated that multiple NICs 1722 can be present in the computing device 1700, connecting the computing device to other types of networks and remote computer systems.

The computing device 1700 can be connected to a mass storage device 1728 that provides non-volatile storage for the computer. The mass storage device 1728 can store system programs, application programs, other program modules, and data, which have been described in greater detail herein. The mass storage device 1728 can be connected to the computing device 1700 through a storage controller 1724 connected to the chipset 1706. The mass storage device 1728 can consist of one or more physical storage units. A storage controller 1724 can interface with the physical storage units through a serial attached SCSI (SAS) interface, a serial advanced technology attachment (SATA) interface, a fiber channel (FC) interface, or other type of interface for physically connecting and transferring data between computers and physical storage units.

The computing device 1700 can store data on a mass storage device 1728 by transforming the physical state of the physical storage units to reflect the information being stored. The specific transformation of a physical state can depend on various factors and on different implementations of this description. Examples of such factors can include, but are not limited to, the technology used to implement the physical storage units and whether the mass storage device 1728 is characterized as primary or secondary storage and the like.

For example, the computing device 1700 can store information to the mass storage device 1728 by issuing instructions through a storage controller 1724 to alter the magnetic characteristics of a particular location within a magnetic disk drive unit, the reflective or refractive characteristics of a particular location in an optical storage unit, or the electrical characteristics of a particular capacitor, transistor, or other discrete component in a solid-state storage unit. Other transformations of physical media are possible without departing from the scope and spirit of the present description, with the foregoing examples provided only to facilitate this description. The computing device 1700 can further read information from the mass storage device 1728 by detecting the physical states or characteristics of one or more particular locations within the physical storage units.

In addition to the mass storage device 1728 described above, the computing device 1700 can have access to other computer-readable storage media to store and retrieve information, such as program modules, data structures, or other data. It should be appreciated by those skilled in the art that computer-readable storage media can be any available media that provides for the storage of non-transitory data and that can be accessed by the computing device 1700.

By way of example and not limitation, computer-readable storage media can include volatile and non-volatile, transitory computer-readable storage media and non-transitory computer-readable storage media, and removable and non-removable media implemented in any method or technology. Computer-readable storage media includes, but is not limited to, RAM, ROM, erasable programmable ROM ("EPROM"), electrically erasable programmable ROM ("EEPROM"), flash memory or other solid-state memory technology, compact disc ROM ("CD-ROM"), digital versatile disk ("DVD"), high definition DVD ("HD-DVD"), BLU-RAY, or other optical storage, magnetic cassettes, magnetic tape, magnetic disk storage, other magnetic storage devices, or any other medium that can be used to store the desired information in a non-transitory fashion.

A mass storage device, such as the mass storage device 1728 depicted in FIG. 17, can store an operating system utilized to control the operation of the computing device 1700. The operating system can comprise a version of the LINUX operating system. The operating system can comprise a version of the WINDOWS SERVER operating system from the MICROSOFT Corporation. According to further aspects, the operating system can comprise a version of the UNIX operating system. Various mobile phone operating systems, such as IOS and ANDROID, can also be utilized. It should be appreciated that other operating systems can also be utilized. The mass storage device 1728 can store other system or application programs and data utilized by the computing device 1700.

The mass storage device 1728 or other computer-readable storage media can also be encoded with computer-executable instructions, which, if loaded into the computing device 1700, transforms the computing device from a general-purpose computing system into a special-purpose computer capable of implementing the aspects described herein. These computer-executable instructions transform the computing device 1700 by specifying how the CPU(s) 1704 transition between states, as described above. The computing device 1700 can have access to computer-readable storage media storing computer-executable instructions, which, if executed by the computing device 1700, can perform the methods described throughout the disclosure.

A computing device, such as the computing device 1700 depicted in FIG. 17, can also include an input/output controller 1732 for receiving and processing input from a number of input devices, such as a keyboard, a mouse, a touchpad, a touch screen, an electronic stylus, or other type of input device. Similarly, an input/output controller 1732 can provide output to a display, such as a computer monitor, a flat-panel display, a digital projector, a printer, a plotter, or other type of output device. It will be appreciated that the computing device 1700 may not include all of the components shown in FIG. 17, can include other components that are not explicitly shown in FIG. 17, or can utilize an architecture completely different than that shown in FIG. 17.

As described herein, a computing device can be a physical computing device, such as the computing device 1700 of FIG. 17. A computing node can also include a virtual machine host process and one or more virtual machine instances. Computer-executable instructions can be executed by the physical hardware of a computing device indirectly through interpretation and/or execution of instructions stored and executed in the context of a virtual machine.

It is to be understood that the methods and systems are not limited to specific methods, specific components, or to particular implementations. It is also to be understood that the terminology used herein is for the purpose of describing particular embodiments only and is not intended to be limiting.

Components are described that can be used to perform the described methods and systems. When combinations, subsets, interactions, groups, etc., of these components are described, it is understood that while specific references to each of the various individual and collective combinations and permutations of these may not be explicitly described, each is specifically contemplated and described herein, for all methods and systems. This applies to all aspects of this application including, but not limited to, operations in described methods. Thus, if there are a variety of additional operations that can be performed it is understood that each of these additional operations can be performed with any specific embodiment or combination of embodiments of the described methods.

As will be appreciated by one skilled in the art, the methods and systems can take the form of an entirely hardware embodiment, an entirely software embodiment, or an embodiment combining software and hardware aspects. Furthermore, the methods and systems can take the form of a computer program product on a computer-readable storage medium having computer-readable program instructions (e.g., computer software) embodied in the storage medium. More particularly, the present methods and systems can take the form of web-implemented computer software. Any suitable computer-readable storage medium can be utilized including hard disks, CD-ROMs, optical storage devices, or magnetic storage devices.

Embodiments of the methods and systems are described herein with reference to block diagrams and flowchart illustrations of methods, systems, apparatuses and computer program products. It will be understood that each block of the block diagrams and flowchart illustrations, and combinations of blocks in the block diagrams and flowchart illustrations, respectively, can be implemented by computer program instructions. These computer program instructions can be loaded on a general-purpose computer, special-purpose computer, or other programmable data processing apparatus to produce a machine, such that the instructions which execute on the computer or other programmable data processing apparatus create a means for implementing the functions specified in the flowchart block or blocks.

These computer program instructions can also be stored in a computer-readable memory that can direct a computer or other programmable data processing apparatus to function in a particular manner, such that the instructions stored in the computer-readable memory produce an article of manufacture including computer-readable instructions for implementing the function specified in the flowchart block or blocks. The computer program instructions can also be loaded onto a computer or other programmable data processing apparatus to cause a series of operational steps to be performed on the computer or other programmable apparatus to produce a computer-implemented process such that the instructions that execute on the computer or other programmable apparatus provide steps for implementing the functions specified in the flowchart block or blocks.

The various features and processes described above can be used independently of one another, or can be combined in various ways. All possible combinations and sub-combinations are intended to fall within the scope of this disclosure. In addition, certain methods or process blocks can be omitted in some implementations. The methods and processes described herein are also not limited to any particular sequence, and the blocks or states relating thereto can be performed in other sequences that are appropriate. For example, described blocks or states can be performed in an order other than that specifically described, or multiple blocks or states can be combined in a single block or state. The example blocks or states can be performed in serial, in parallel, or in some other manner. Blocks or states can be added to or removed from the described example embodiments. The example systems and components described herein can be configured differently than described. For example, elements can be added to, removed from, or rearranged compared to the described example embodiments.

It will also be appreciated that various items are illustrated as being stored in memory or on storage while being used, and that these items or portions thereof can be transferred between memory and other storage devices for purposes of memory management and data integrity. Alternatively, in other embodiments, some or all of the software modules and/or systems can execute in memory on another device and communicate with the illustrated computing systems via inter-computer communication. Furthermore, in some embodiments, some or all of the systems and/or modules can be implemented or provided in other ways, such as at least partially in firmware and/or hardware, including, but not limited to, one or more application-specific integrated circuits ("ASICs"), standard integrated circuits, controllers (e.g., by executing appropriate instructions, and including microcontrollers and/or embedded controllers), field-programmable gate arrays ("FPGAs"), complex programmable logic devices ("CPLDs"), etc. Some or all of the modules, systems, and data structures can also be stored (e.g., as software instructions or structured data) on a computer-readable medium, such as a hard disk, a memory, a network, or a portable media article to be read by an appropriate device or via an appropriate connection. The systems, modules, and data structures can also be transmitted as generated data signals (e.g., as part of a carrier wave or other analog or digital propagated signal) on a variety of computer-readable transmission media, including wireless-based and wired/cable-based media, and can take a variety of forms (e.g., as part of a single or multiplexed analog signal, or as multiple discrete digital packets or frames). Such computer program products can also take other forms in other embodiments. Accordingly, the present invention can be practiced with other computer system configurations.

The present disclosure can comprise at the least the following aspects.
Aspect 1. A device comprising, consisting of, or consisting essentially of: a thin-film triboelectric layer configured to output a current (e.g., current signal) in response to an interaction (e.g., contact, mechanical contact, mechanical force, electrical force, contact event, proximity event) with an object; an electrode disposed adjacent (e.g., coupled to) the triboelectric layer; and a processing unit electrically coupled, via at least the electrode, to the triboelectric layer and configured to receive the current and determine, based on the current, a material (e.g., element, compound, composite material, name of the material) of the object.
Aspect 2. The device of aspect 1, wherein the triboelectric layer comprises one or more of photoactive polycarbonate thermoplastic material (XPC) or isofluoropropyl polyhedral oligomeric silsesquioxane (F-POSS).
Aspect 3. The device of any one of aspects 1-2, wherein the processing unit is configured to determine the material of the object based on determining that the current has a current characteristic associated with the material.
Aspect 4. The device of aspect 3, wherein the current characteristic comprises a current level.
Aspect 5. The device of any one of aspects 1-4, wherein the triboelectric layer has a first side comprising a surface patterning, and wherein the interaction is with the first side.
Aspect 6. The device of any one of aspects 1-5, wherein the interaction comprises the object contacting the triboelectric layer.
Aspect 7. The device of any one of aspects 1-6, further comprising a readout circuit electrically coupled between the triboelectric layer and the processing unit, wherein the readout circuit is configured to generate a voltage (e.g., voltage signal) based on the current, wherein the processing unit is configured to determine one or more of a force of the interaction or an occurrence of the interaction.
Aspect 8. A method comprising, consisting of, or consisting essentially of: receiving an interaction (e.g., mechanical contact, mechanical force, electrical force, contact event, proximity event) of an object with a thin-film triboelectric layer; generating, by the triboelectric layer and based on the interaction, a current (e.g., a current signal); determining, by computer processor and based on the current, a material (e.g., element, compound, composite material, name of a material) of the object; and sending (e.g., sending to a display, sending via a network to a computing device), by the computer processor, data indicative of the material.
Aspect 9. The method of aspect 8, wherein the triboelectric layer comprises one or more of photoactive polycarbonate thermoplastic material (XPC) or isofluoropropyl polyhedral oligomeric silsesquioxane (F-POSS).
Aspect 10. The method of any one of aspects 8-9, wherein determining the material of the object comprises determining that the current has a current characteristic associated with the material.
Aspect 11. The method of aspect 10, wherein the current characteristic comprises a current level.
Aspect 12. The method of any one of aspects 8-11, wherein the triboelectric layer has a first side comprising a surface patterning, and wherein the interaction is with the first side.
Aspect 13. The method of any one of aspects 8-12, wherein the receiving the interaction comprises receiving by the triboelectric layer contact from the object.
Aspect 14. The method of any one of claims 8-13, further comprising generating a voltage (e.g., voltage signal) based on the current and determining, based on the voltage, one or more of a force of the interaction or an occurrence of the interaction.
Aspect 15. A system comprising, consisting of, or consisting essentially of: a plurality of sensors, wherein at least one of the plurality of sensors comprises a thin-film triboelectric layer configured to output a current (e.g., current signal) in response to an interaction (e.g., contact, mechanical contact, mechanical force, electrical force, contact event, proximity event) with an object; and one or more processors electrically coupled to the plurality of sensors, wherein the one or more processors are configured to receive the current and determine, based on the current, a material (e.g., element, compound, composite material, name of a material) of the object.
Aspect 16. The system of aspect 15, wherein the plurality of sensors comprises a first sensor associated with detection of materials and a second sensor associated with detection of touch events.
Aspect 17. The system of any one of aspects 15-16, wherein the triboelectric layer comprises one or more of photoactive polycarbonate thermoplastic material (XPC) or isofluoropropyl polyhedral oligomeric silsesquioxane (F-POSS).
Aspect 18. The system of any one of aspects 15-17, wherein the one or more processors are configured to determine the material of the object based on determining that the current has a current characteristic associated with the material.
Aspect 19. The system of aspect 8, wherein the current characteristic comprises a current level.
Aspect 20. The system of any one of aspects 15-19, wherein the triboelectric layer has a first side comprising a surface patterning, and wherein the interaction is with the first side.
Aspect 21. The system of any one of aspects 15-20, wherein the interaction comprises the object contacting the triboelectric layer.
Aspect 22. The system of any one of aspects 15-21, further comprising a readout circuit electrically coupled between the triboelectric layer and the one or more processors, wherein the readout circuit is configured to generate a voltage (e.g., voltage signal) based on the current, wherein the one or more processors are configured to determine one or more of a force of the interaction or an occurrence of the interaction.
Aspect 23. A device for translating mechanical force into electrical energy, the device comprising, consisting of, or consisting essentially of: a thin-film triboelectric layer; and an electrode coupled to the triboelectric layer, wherein the thin-film triboelectric layer is configured to output, to a circuit element (e.g., controller, processor, microcontroller, logic gate, integrated circuit, chip) and based on mechanical contact with an object, a current (e.g., a current signal) indicative of a material of the object, and wherein the circuit element is configured to output a signal (e.g., or data) indicative of the material.
Aspect 24. The device of aspect 23, further comprising the circuit element, wherein the circuit element comprises a processing unit electrically coupled, via at least the electrode, to the thin-film triboelectric layer and configured to output an indication of the material of the object based on a current characteristic of the current.
Aspect 25. The device of aspect 24, wherein the processing unit is configured to determine the material based on an association of the current characteristic with the material.
Aspect 26. The device of any one of aspects 24-25, wherein the current characteristic comprises a current level.
Aspect 27. The device of any one of aspects 23-26, wherein the triboelectric layer has a first side comprising a surface patterning, and wherein the mechanical contact is with the first side.
Aspect 28. The device of any one of aspects 23-27, wherein the triboelectric layer comprises one or more of photoactive polycarbonate thermoplastic material (XPC) or isofluoropropyl polyhedral oligomeric silsesquioxane (F-POSS).
Aspect 29. The device of any one of aspects 23-28, further comprising a readout circuit electrically coupled between the triboelectric layer and a processing unit, wherein the readout circuit is configured to generate a voltage (e.g., voltage signal) based on the current signal, wherein the processing unit is configured to determine one or more of a force of the mechanical contact or an occurrence of the mechanical contact.

### Definitions

It is also to be understood that the terminology used herein is for the purpose of describing particular aspects only and is not intended to be limiting.

Throughout the description and claims of this specification, the word "comprise" and variations of the word, such as "comprising" and "comprises," means "including but not limited to," and is not intended to exclude, for example, other components, integers or steps. The term "comprising" can include the embodiments "consisting of' and "consisting essentially of." "Exemplary" means "an example of' and is not intended to convey an indication of a preferred or ideal embodiment. "Such as" is not used in a restrictive sense, but for explanatory purposes.

Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional additives" means that the additional additives can or cannot be included and that the description includes compositions that both include and do not include additional additives.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included. As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application. Each of the materials disclosed herein are either commercially available and/or the methods for the production thereof are known to those of skill in the art. It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%. While "about" permits some tolerance, a person of ordinary skill in the art would read the specification in light of his knowledge and skill for guidance on the level of that tolerance, and be reasonably apprised to a reasonable degree the metes and bounds of the claims.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading can occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation. The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which can be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "polymer" refers to a molecule having at least one repeating unit and can include copolymers and homopolymers. The polymers described herein can terminate in any suitable way. In some embodiments, the polymers can terminate with an end group that is independently chosen from a suitable polymerization initiator, -H, - OH, a substituted or unsubstituted (C₁-C₂₀)hydrocarbyl (e.g., (Ci-Cio)alkyl or (C₆-C₂₀)aryl) interrupted with 0, 1, 2, or 3 groups independently selected from -O-, substituted or unsubstituted -NH-, and -S-, a poly(substituted or unsubstituted (C₁-C₂₀)hydrocarbyloxy), and a poly(substituted or unsubstituted (C₁-C₂₀)hydrocarbylamino).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code can form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

All publications mentioned herein are incorporated herein by reference to disclose and describe the methods and/or materials in connection with which the publications are cited. The above description is intended to be illustrative, and not restrictive. For example, the above-described examples (or one or more aspects thereof) can be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features can be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A device comprising:
a thin film triboelectric layer configured to output a current in response to contact with an object;
an electrode coupled to the triboelectric layer; and
a processing unit electrically coupled, via at least the electrode, to the triboelectric layer and configured to receive the current and determine, based on the current, a material of the object.

2. The device of claim 1, wherein the triboelectric layer comprises one or more of photoactive polycarbonate thermoplastic material (XPC) or isofluoropropyl polyhedral oligomeric silsesquioxane (F-POSS).

3. The device of any one of claims 1-2, wherein the processing unit is configured to determine the material of the object based on determining that the current has a current characteristic associated with the material.

4. The device of claim 3, wherein the current characteristic comprises a current level.

5. The device of any one of claims 1-4, wherein the triboelectric layer has a first side comprising a surface patterning.

6. The device of claim 5, wherein the contact is with the first side.

7. The device of any one of claims 1-6, further comprising a readout circuit electrically coupled between the triboelectric layer and the processing unit, wherein the readout circuit is configured to generate a voltage signal based on the current, wherein the processing unit is configured to determine one or more of a force of the contact or an occurrence of the contact.

8. A method comprising:
receiving contact of an object with a thin film triboelectric layer;
generating, by the triboelectric layer and based on the contact, a current;
determining, by the computer processor and based on the current, a material of the object; and
sending, by the computer processor, data indicative of the material.

9. The method of claim 8, wherein the triboelectric layer comprises one or more of photoactive polycarbonate thermoplastic material (XPC) or isofluoropropyl polyhedral oligomeric silsesquioxane (F-POSS).

10. The method of any one of claims 8-9, wherein determining the material of the object comprises determining that the current has a current characteristic associated with the material.

11. The method of claim 10, wherein the current characteristic comprises a current level.

12. The method of any one of claims 8-11, wherein the triboelectric layer has a first side comprising a surface patterning.

13. The method of claim 12, wherein the contact is with the first side.

14. The method of any one of claims 8-13, further comprising generating a voltage based on the current and determining, based on the voltage, one or more of a force of the contact or an occurrence of the contact.

15. A system comprising:
a plurality of sensors, wherein at least one of the plurality of sensors comprises a thin film triboelectric layer configured to output a current in response to contact with an object; and
one or more processors electrically coupled to the plurality of sensors, wherein the one or more processors are configured to receive the current and determine, based on the current, a material of the object.
